# EUROPÄISCHE PATENTSCHRIFT

(11) **EP 2 281 317 B1**
(45) Veröffentlichungstag und Bekanntmachung des Hinweises auf die Patenterteilung: **19.11.2014**
(21) Anmeldenummer: 09753517.3
(22) Anmeldetag: 07.05.2009
(51) Int. Cl.: H01L 51/50

(54) **ORGANISCHES LICHT EMITTIERENDES BAUTEIL UND LEUCHTMITTEL MIT EINEM SOLCHEN BAUTEIL**
ORGANIC LIGHT EMITTING COMPONENT AND ILLUMINATION MEANS COMPRISING A COMPONENT OF THIS TYPE
ELEMENT ORGANIQUE EMETTANT DE LA LUMIERE ET LUMINAIRE DOTE D'UN ELEMENT DE CE TYPE

(30) Priorität: 29.05.2008 DE 102008025755
(43) Veröffentlichungstag der Anmeldung: 09.02.2011
(73) Patentinhaber: Osram Opto Semiconductors Gmbh, 93055 Regensburg (DE)
(72) Erfinder: DOBBERTIN, Thomas, 93051 Regensburg (DE); RIEGEL, Nina, 93105 Tegernheim (DE)
(74) Vertreter: Epping - Hermann - Fischer
(86) Internationale Anmeldenummer: PCT/DE2009/000644
(87) Internationale Veröffentlichungsnummer: WO 2009/143801

(56) Entgegenhaltungen:
- EP-A- 1 388 904
- WANG Y Z ET AL: "ALTERNATING-CURRENT LIGHT-EMITTING DEVICES BASED ON CONJUGATED POLYMERS" APPLIED PHYSICS LETTERS, AIP, AMERICAN INSTITUTE OF PHYSICS, MELVILLE, NY, US, Bd. 68, Nr. 7, 12. Februar 1996 (1996-02-12), Seiten 894-896, XP000559954 ISSN: 0003-6951
- WELTER S ET AL: "ELECTROLUMINESCENT DEVICE WITH REVERSIBLE SWITCHING BETWEEN RED AND GREEN EMISSION" NATURE, NATURE PUBLISHING GROUP, LONDON, UK, Bd. 42, Nr. 6918, 2. Januar 2003 (2003-01-02), Seiten 54-57, XP001190898 ISSN: 0028-0836
- HWANG M-Y ET AL: "Poly(pyridine-2,5-diyl) as electron-transport/hole blocking layer in poly(phenylene vinylene) light-emitting diode" POLYMER, ELSEVIER SCIENCE PUBLISHERS B.V, GB, Bd. 40, Nr. 11, 1. Mai 1999 (1999-05-01), Seiten 3233-3235, XP004157677 ISSN: 0032-3861

## Beschreibung

Es wird ein organisches Licht emittierendes Bauteil sowie ein Leuchtmittel mit einem solchen Bauteil angegeben.

Elektromagnetische Strahlung emittierende oder auch empfangende Bauteile auf der Basis von Halbleitermaterialien haben breite technische Anwendung und vielfältigen Einzug in den Alltag gefunden. Gängige Halbleitermaterialien können grob in zwei Klassen eingeteilt werden: organische und anorganische Halbleitermaterialien. Organische Halbleitermaterialien können verhältnismäßig kostengünstig hergestellt und vergleichsweise einfach auf einem Träger aufgebracht werden. Weiterhin bieten organische Halbleitermaterialien gegenüber anorganischen die Möglichkeit, prinzipiell sehr großflächige, Licht emittierende oder auch Licht empfangende Anordnungen zu realisieren.

Herkömmliche Leuchtdioden auf organischer als auch auf anorganischer Basis werden mit Gleichstrom betrieben. Normale Stromnetze stellen allerdings nur Wechselstrom zur Verfügung. Daher müssen zum Betreiben einer LED mit Netzspannung zusätzliche Elemente, wie zum Beispiel Gleichrichterschaltungen eingesetzt werden. Durch die Verwendung von Gleichstrom allerdings ist die Ausnützung von Vorteilen, die mit Wechselstrom einhergehen können, wie zum Beispiel einfache Transformation der Spannung, nicht oder nur sehr eingeschränkt möglich.

In dem Artikel "Alternating-current light-emitting devices based on conjugated polymers" von Y. Z. Wang et al. in Applied Physics Letters, Nummer 68(7) vom 12. Februar 1996, Seiten 894 bis 896, ist eine organische Leuchtdiode angegeben.

Die Druckschrift "Electroluminescent device with reversible switching between red and green emission" von S. Welter et al. in Nature, Jahrgang 2003, Nummer 42, Seiten 54-57, offenbart eine organische Leuchtidode.

Eine organische Leuchtdiode ist in der Druckschrift EP 1 388 904 A2 beschrieben.

Eine zu lösende Aufgabe besteht darin, ein organisches Licht emittierendes Bauteil anzugeben, das effizient mit Wechselstrom betrieben werden kann. Eine weitere zu lösende Aufgabe besteht darin, ein Leuchtmittel mit einem solchen Bauteil anzugeben.

Das organische Licht emittierende Bauteil umfasst eine unipolare Ladungsträgersperrschicht, die insbesondere auf organischem Material basieren kann. Unter einer solchen Ladungsträgersperrschicht wird eine Schicht verstanden, die eine Art Ladungsträger nicht oder nur sehr eingeschränkt passieren lässt. Unipolar bedeutet also, dass die Ladungsträgersperrschicht entweder positive oder negative Ladungsträger in ihrer Beweglichkeit stark beeinträchtigt beziehungsweise deren Durchtritt durch die Ladungsträgersperrschicht unterbindet, während hingegen Ladungsträger mit entgegengesetzter Ladung die Ladungsträgersperrschicht passieren können. Negative Ladungsträger sind beispielsweise Elektronen, positive Ladungsträger beispielsweise so genannte Löcher, englisch holes.

Das organische Licht emittierende Bauteil umfasst mindestens eine erste und eine zweite Schicht, die dazu ausgestaltet sind, im Betrieb Licht zu emittieren. Diese Schichten sind mit mindestens einem organischen Material gebildet. Die Schichten sind dazu ausgestaltet, im Betrieb elektromagnetische Strahlung im ultravioletten, sichtbaren und/oder nah-infraroten Spektralbereich zu emittieren. Bevorzugt emittiert das organische Bauteil Licht, das im Spektralbereich zwischen 200 nm und 3000 nm, besonders bevorzugt zwischen 300 nm und 950 nm, ganz besonders bevorzugt zwischen zirka 380 nm und 780 nm liegt.

Es weist das organische Licht emittierende Bauteil mindestens eine ambipolare Injektionsschicht auf, die dazu geeignet ist, sowohl positive als auch negative Ladungsträger in die Licht emittierende Schicht injizieren zu können.

Das organische Licht emittierende Bauteil umfasst eine erste und eine zweite Elektrode, die an den der Ladungsträgersperrschicht abgewandten Seiten der ambipolaren Injektionsschichten aufgebracht sind. Die erste und/oder die zweite Elektrode können jeweils großflächig ausgebildet sein. Dadurch kann eine großflächige Abstrahlung der in einem aktiven Bereich erzeugten elektromagnetischen Strahlung ermöglicht werden. "Großflächig" kann dabei bedeuten, dass das organische, elektronische Bauteil eine Fläche von größer oder gleich einigen Quadratmillimetern, bevorzugt größer oder gleich einem Quadratzentimeter und besonders bevorzugt größer oder gleich einem Quadratdezimeter aufweist. Alternativ oder zusätzlich können die erste und/oder die zweite Elektrode zumindest in Teilbereichen strukturiert ausgebildet sein. Dadurch kann eine strukturierte Abstrahlung der im aktiven Bereich erzeugten elektromagnetischen Strahlung ermöglicht werden, etwa in Form von Pixel oder Piktogrammen.

Gemäß mindestens einer Ausführungsform des organischen Bauteils sind beide Elektroden mindestens teilweise transparent gestaltet. Gemäß mindestens einer anderen Ausführungsform ist eine Elektrode mindestens teilweise transparent, die andere Elektrode mindestens teilweise reflektierend für die im Betrieb des Bauteils emittierte Strahlung ausgeführt. Geeignete Elektrodenmaterialien sind zum Beispiel transparente, leitende Oxide, so genannte transparent conductive oxides oder kurz TCOs. Diese sind in der Regel Metalloxide, wie beispielsweise Zinkoxid, Zinnoxid, Cadmiumoxid, Titanoxid, Indiumoxid oder Indium-Zinnoxid, das auch als ITO bekannt ist. Neben binären Metall-SauerstoffVerbindungen, wie beispielsweise die oben genannten Metalloxide, gehören auch tertiäre Metall-SauerstoffVerbindungen, wie beispielsweise Zn₂SnO₄, oder Mischungen unterschiedlicher, transparenter leitender Oxide zu der Gruppe der TCOs. Weiterhin eignen sich für die Elektroden Metalle, wie beispielsweise Aluminium, Barium, Indium, Silber, Gold, Magnesium, Calcium oder Lithium sowie Verbindungen, Kombinationen oder Legierungen davon. Ebenso können die Elektroden mindestens teilweise mit einem organischen Material gebildet sein. Die Elektroden können auch so ausgebildet sein, dass diejenigen Teile der Elektroden, die in direktem Kontakt zum Beispiel zu einer Injektionsschicht stehen, mit einem anderen Material gebildet sind als die restlichen Teile der Elektroden.

Eine oder auch mehrere der organischen funktionellen Schichten, wie zum Beispiel die Ladungsträgersperrschicht, die Injektionsschichten, die Elektroden oder die im Betrieb des Bauteils Licht emittierenden Schichten, können organische Polymere, organische Olygomere, organische Monomere, organische kleine, nicht-polymere Moleküle, so genannte small molecules, oder Kombinationen daraus aufweisen. Insbesondere kann es vorteilhaft sein, wenn die organische strahlungsemittierende Schichtenfolge eine funktionelle Schicht aufweist, die als Lochtransportschicht ausgeführt ist, um eine effektive beispielsweise Löcherinjektion in eine zum Beispiel elektrolumineszierende Schicht oder einen elektrolumineszierenden Bereich zu ermöglichen. Als Materialien für eine Lochtransportschicht können sich beispielsweise tertiäre Amine, Carbazolderivate, leitendes Polyanilin oder Polyethylendioxythiophen als vorteilhaft erweisen. Weiterhin kann es vorteilhaft sein, wenn die funktionelle Schicht als elektrolumineszierende Schicht ausgeführt ist. Als Materialien eignen sich solche, die eine Strahlungsemission aufgrund von Fluoreszenz oder Phosphoreszenz aufweisen, beispielsweise Polyfluorin, Polythiophen oder Polyphenylen oder Derivate, Verbindungen, Mischungen oder Copolymere davon.

Das organische Licht emittierende Bauteil umfasst eine unipolare Ladungsträgersperrschicht, eine erste Schicht und eine zweite Schicht, die an gegenüberliegenden Seiten der Ladungsträgersperrschicht aufgebracht und jeweils mit mindestens einem organischen Material gebildet sind, sowie zwei ambipolare Injektionsschichten, die an den der Ladungsträgersperrschicht abgewandten Seiten der ersten und der zweiten Schicht aufgebracht sind.

Ein derartiges organisches, Licht emittierendes Bauteil kann effizient mit Wechselstrom betrieben werden. Da sich über den Betrieb mit Wechselspannung keine langlebigen Raumladungszonen im organischen Licht emittierenden Bauteil ausbilden und außerdem die Diffusion von Ionen innerhalb des Bauteils durch den Wechselstrombetrieb unterdrückt wird, erhöht sich außerdem die Lebensdauer des organischen Licht emittierenden Bauteils.

Gemäß zumindest einer Ausführungsform des organischen Licht emittierenden Bauteils umfasst diese eine Regeleinheit für Wechselstrom. Eine solche Regeleinheit kann beispielsweise von einem Transformator gebildet werden, der die Netzspannung in eine Wechselspannung mit niedrigerer Effektivspannung umwandelt. Außerdem kann die Regeleinheit eine strom-und/oder spannungsbegrenzende Funktion erfüllen. Die Regeleinheit ist insbesondere keine Gleichstromquelle. Eine solche Regeleinheit kann verhindern, dass durch zu hohe Ströme oder zu hohe Spannungen das organische Licht emittierende Bauteil im Betrieb zerstört wird.

Gemäß zumindest einer Ausführungsform des Bauteils, bei dem dieses mit einer Regeleinheit für Wechselstrom versehen ist, wird über diese Regeleinheit mindestens eine der Kenngrößen Amplituden, Amplitudenverhältnis oder Tastverhältnis des Wechselstroms gesteuert. Wechselstrom weist definitionsgemäß eine Phase mit positiver Spannung und eine Phase mit negativer Spannung auf. Unter Amplituden sind die Effektivspannungen der positiven und negativen Phase zu verstehen. Mit Amplitudenverhältnis ist das Verhältnis der Effektivspannungen von positiver und negativer Phase zu verstehen. Das Tastverhältnis ist definiert als das Verhältnis aus Zeitdauer der Phase mit positiver Spannung und der Zeitdauer von positiver und negativer Phase zusammen.

Insbesondere können über die Regeleinheit alle Größen Amplituden, Amplitudenverhältnis und Tastverhältnis unabhängig voneinander angesteuert werden. Bevorzugt kann die Regeleinheit auch die sinusförmige Wechselspannung aus dem herkömmlichen Stromnetz in andere Spannungsformen, beispielsweise in eine Rechteckspannung, umwandeln. Über eine solche Regeleinheit kann die Stromversorgung von erster Schicht und zweiter Schicht variabel eingestellt werden und die Möglichkeiten, das im Betrieb des organischen Bauteils abgestrahlte Lichtspektrum zu gestalten, erhöhen sich hierdurch.

Gemäß zumindest einer Ausführungsform des Bauteils ist die Regeleinheit für den Wechselstrom mindestens zum Teil organisch ausgeführt. Organisch ausgeführt meint hierbei nicht, dass für die Funktion nicht essentielle Teile wie Gehäuse der Regeleinheit oder Isoliermaterialien elektrischer Leitungen aus organischen Materialien wie Kunststoffen bestehen. Gemeint ist, dass funktionsessentielle Bestandteile, wie etwa Verstärkerschaltungen oder Sensoren, mindestens zum Teil auf organischen Materialien beruhen. Über eine solche Regeleinheit sind Licht emittierende Schichten und Regeleinheit selbst in der gleichen, auf organischen Materialien basierenden Technologie erzeugbar. Dies kann den Fertigungsaufwand reduzieren. Zudem kann die Regeleinheit bei Wahl geeigneter organischer Materialien mindestens zum Teil transparent gestaltet und/oder auf einem gleichen Träger wie die Licht emittierenden Schichten aufgebracht sein.

Gemäß zumindest einer Ausführungsform des Bauteils emittieren in dessen Betrieb erste und zweite Schicht abwechselnd Licht. Das heißt, die Rekombination von positiven und negativen Ladungsträgern findet abwechselnd in der ersten und der zweiten Schicht statt. Da durch die Ladungsträgersperrschicht beispielsweise positive Ladungsträger am Durchlaufen dieser Sperrschicht gehindert werden, sammeln sich die positiven Ladungsträger, in Abhängigkeit der anliegenden Phase der Wechselspannung, entweder in der ersten oder der zweiten Schicht. Da negative Ladungsträger wie Elektronen eine derartig gestaltete Ladungsträgersperrschicht durchdringen können, können diese unabhängig von der anliegenden Phase sowohl erste als auch zweite Schicht durchlaufen. Das heißt, in diesem Falle leuchtet jeweils diejenige Schicht, die mit der Anode verbunden ist.

Wird das Bauteil zum Beispiel mit einer Wechselspannung mit einer Frequenz von 50 Hertz betrieben, wie diese für das herkömmliche Stromnetz üblich ist, so kann das Bauteil, da erste und zweite Schicht abwechselnd mit 50 Hertz leuchten, mit 100 Hertz Licht emittieren. Bei derart hohen Frequenzen nimmt das menschliche Auge kein Flimmern mehr wahr und das Bauteil eignet sich beispielsweise als Leuchtmittel zu Zwecken der Allgemeinbeleuchtung. Da außerdem sowohl in der Phase mit negativer als auch in der Phase mit positiver Spannung Licht emittiert wird, kann die Betriebsspannung beziehungsweise der Betriebsstrom gegenüber einer herkömmlichen, mit Wechselspannung betriebenen organischen oder anorganischen Leuchtdiode, die nur während beispielsweise der negativen Phase Licht emittiert, bei gleicher emittierter Lichtleistung näherungsweise halbiert werden. Durch Reduzierung von Betriebsstrom beziehungsweise -spannung erhöht sich die Lebensdauer des organischen Bauteils.

Gemäß zumindest einer Ausführungsform des organischen Licht emittierenden Bauteils ist die Ladungsträgersperrschicht durchgehend und unstrukturiert. Das heißt, dass die Ladungsträgersperrschicht mindestens im Rahmen üblicher Herstellungstoleranzen mit einer gleichen Dicke und Materialzusammensetzung zwischen erster und zweiter Schicht ausgeprägt ist. Das heißt insbesondere, dass erste und zweite Licht emittierende Schicht an keiner Stelle in direktem Kontakt zueinander stehen. Eine solche durchgehende und unstrukturierte Schicht ist besonders effektiv aufzubringen. Über eine solche Schicht kann der Herstellungsaufwand reduziert werden.

Gemäß zumindest einer Ausführungsform des organischen Licht emittierenden Bauteils sind erste und zweite Schicht derart ausgestaltet, dass sie im Betrieb des Bauteils Licht in verschiedenen Wellenlängenbereichen emittieren. Die von erster und zweiter Schicht emittierten Wellenlängen können allerdings teilweise überlappen. Bevorzugt emittiert eine der beiden Schichten Licht im blauen oder UV-Spektralbereich und die andere Schicht Licht im grünen oder roten Spektralbereich. Über verschiedenfarbig strahlende Schichten kann die farbliche Gestaltung beziehungsweise das Gesamtspektrum des vom organischen Bauteil emittierten Lichts vielfältig eingestellt werden.

Gemäß zumindest einer Ausführungsform des organischen Licht emittierenden Bauteils können über die Regeleinheit für Wechselspannung mindestens eine der Kenngrößen Farbton, Farbsättigung und Helligkeit gesteuert werden. Bevorzugt können über die Regeleinheit alle drei genannten Kenngrößen unabhängig voneinander angesteuert werden. Über eine solche Regeleinheit kann die Abstrahlcharakteristik des Bauteils gezielt eingestellt werden.

Gemäß zumindest einer Ausführungsform des organischen Licht emittierenden Bauteils umfasst dieses mindestens einen Sensor. Der Sensor kann in Form einer Fotodiode ausgestaltet sein. Bevorzugt basiert der Sensor mindestens zum Teil auf organischen Materialien. Über den Sensor und die Regeleinheit für Wechselstrom kann das vom Spektrum des Bauteil im Betrieb emittierten Lichts etwa automatisch geregelt werden.

Gemäß zumindest einer Ausführungsform des organischen Licht emittierenden Bauteils ist über einer der Ladungsträgersperrschicht abgewandten Seite von erster und/oder zweiter Schicht mindestens ein Konversionsmittel aufgebracht, das mindestens einen Teil der im Betrieb von erster und zweiter Schicht emittierten Strahlung in eine Strahlung einer anderen Frequenz umwandelt. Bevorzugt ist das Konversionsmittel nur über einer der beiden Schichten aufgebracht. Ist aber das Konversionsmittel über beiden Schichten aufgebracht, so konvertiert das Konversionsmittel in diesem Fall bevorzugt nur Strahlung einer der beiden Schichten. Das Konversionsmittel kann beispielsweise als organischer oder anorganischer Lumineszenzfarbstoff ausgestaltet sein. Bevorzugt konvertiert das Konversionsmittel nur einen Teil der beispielsweise von der ersten Schicht emittierten Strahlung, so dass ein mehrfarbig abstrahlendes Bauteil resultiert. Ein solches Bauteil kann bezüglich der spektralen Charakteristik des emittierten Lichts vielfältig gestaltet sein.

Gemäß zumindest einer Ausführungsform des organischen Licht emittierenden Bauteils umfasst dieses mindestens ein Substrat mit zumindest einer Montageseite, wobei über der Montageseite im Betrieb Licht emittierende erste Schicht, Ladungsträgersperrschicht, im Betrieb Licht emittierende zweite Schicht sowie die ambipolaren Injektionsschichten aufgebracht sind. Das Substrat ist hierbei für das im Betrieb des Bauteils emittierte Licht zumindest teilweise durchlässig. Über ein solches mindestens teilweise transparentes oder transluzentes Substrat ist es möglich, eine nach beiden Seiten des Bauteils emittierende Anordnung zu erzielen. Ebenso kann auf diese Weise ein Bauteil realisiert werden, das mindestens teilweise und mindestens in bestimmten Teilen des sichtbaren Spektralbereichs durchlässig ausgestaltet ist.

Gemäß zumindest einer Ausführungsform des organischen Llicht emittierende Bauteils ist dessen Substrat zumindest teilweise reflektierend ausgestaltet. Das Substrat kann also als Reflektor für das im Betrieb emittierte Licht dienen. Über ein derartiges Substrat kann ein organisches Bauteil realisiert werden, das mit hoher Intensität Licht auf nur eine Seite aussendet.

Gemäß zumindest einer Ausführungsform des organischen Licht emittierenden Bauteils weist dessen Substrat eine Strukturierung etwa in Form von Ausnehmungen, Aussparungen oder Einbuchtungen auf, in denen die verschiedenen organischen Schichten des Bauteils angebracht sind. Die Ausnehmung kann den verschiedenen organischen Schichten Schutz bieten oder auch als Reflektor ausgestaltet sein. Ebenso ist es möglich, dass auf dem Substrat Strukturierungen beispielsweise zur Verbesserung der Lichtauskopplung aufgebracht sind. Auch linsenartige Strukturierungen, wie etwa Fresnel-Linsen, sind erstellbar.

Gemäß zumindest einer Ausführungsform des organischen Licht emittierenden Bauteils umfasst dieses mindestens eine Deckplatte. Die Deckplatte kann aus dem selben Material wie das Substrat oder aus einem anderen Material bestehen. Mögliche Materialien, aus denen Substrat und/oder Deckplatte bestehen können, sind Gläser, Quarze, Kunststoff-Folien, Metalle, Metallfolien, TCOs, Siliziumwafer oder andere geeignete Halbleitermaterialien. Auch Verbundmaterialien sind verwendbar. Bevorzugt sind auf Substrat und/oder Deckplatte elektrische Leitungen aufgebracht, die zur elektrischen Kontaktierung des organischen Bauteils dienen können. Besonders bevorzugt sind Substrat und/oder Deckplatte aus Kalk-Natron-Glas beziehungsweise Fensterglas gebildet. Bevorzugt bestehen Substrat und Deckplatte aus demselben Material und/oder weisen dieselben physikalischen und chemischen Eigenschaften auf. Über die Verwendung derartiger Materialien kann das organische Bauteil kosteneffizient hergestellt und dessen mechanische oder chemische Eigenschaften gezielt eingestellt werden.

Gemäß zumindest einer Ausführungsform des organischen Llicht emittierenden Bauteils weist das Substrat und/oder die Deckplatte eine Haft vermittelnde Schicht auf, über die das Bauteil etwa an einem externen Träger befestigt werden kann. Die Hhaft vermittelnde Schicht kann eine durch eine adhäsive Mikrostrukturierung oder durch eine Kleberschicht gebildet werden. Bevorzugt sind elektrische Anschlüsse zur Kontaktierung der Bauteils so nach außen geführt, dass über ein mechanisches Befestigen des Bauteils gleichzeitig dessen elektrische Kontaktierung erfolgt.

Gemäß zumindest einer Ausführungsform des organischen Licht emittierenden Bauteils sind Substrat und Deckplatte über ein Verbindungsmittel miteinander mechanisch verbunden. Bevorzugt kapselt das Verbindungsmittel zudem die organischen Schichten gegenüber Umwelteinflüssen wie Feuchtigkeit und Sauerstoff ab. Das Verbindungsmittel ist bevorzugt mit einem Glaslot, mit Glasfritten, mit einem Harz oder mit einem Metall gestaltet. Besonders bevorzugt weist das Verbindungsmittel einen deutlich niedrigeren Schmelzpunkt auf als Substrat und/oder Deckplatte. Ebenso ist das Verbindungsmittel bevorzugt etwa über elektromagnetische Strahlung oder elektromagnetische Felder schmelzbar, aufweichbar oder aushärtbar. Über ein derartiges Verbindungsmittel kann ein langlebiges organisches Bauteil realisiert werden.

Gemäß zumindest einer Ausführungsform des organischen Licht emittierenden Bauteils ist dem Substrat und/oder der Deckplatte und/oder dem Verbindungsmittel mindestens eine Beimengung beigegeben. Die Beimengung ist beispielsweise als Filtermittel, als Konversionsmittel, als Diffusionsbeziehungsweise Streumittel oder als Reflexionsmittel ausgestaltet. Über die Beimengung kann auch eine Anpassung der thermischen Ausdehnungskoeffizienten etwa von Verbindungsmittel und Substrat erfolgen. Über derartige Beimengungen können die physikalischen und chemischen Eigenschaften von Substrat, Deckplatte und/oder Verbindungsmittel in einem weiten Bereich gezielt eingestellt werden.

Gemäß zumindest einer Ausführungsform des organischen Licht emittierenden Bauteils weist dieses Absorbermaterialien oder Getter auf, die für die organischen Schichten schädliche Substanzen binden. Insbesondere kann das Absorbermaterial Feuchtigkeit und Sauerstoff binden. Das Absorbermaterial kann die organischen Schichten umhüllen oder zwischen Substrat und Deckplatte angebracht sein und die aktiven Schichten beispielsweise ringförmig oder rahmenartig umgeben. Über die Verwendung eines Absorbermaterials kann die Lebensdauer des Bauteils erhöht werden.

Gemäß zumindest einer Ausführungsform des organischen Licht emittierenden Bauteils weist dieses Abstandshalter beziehungsweise Spacer-Partikel auf, über die der Abstand zwischen Substrat und Deckplatte eingestellt wird. Der Einsatz von Abstandshaltern kann die Herstellung des Bauteils vereinfachen.

Gemäß zumindest einer Ausführungsform des organischen Licht emittierenden Bauteils ist dieses zumindest teilweise transparent ausgestaltet. Dies kann insbesondere bedeuten, dass die verschiedenen organischen Schichten sowie die Elektroden aus Materialien gebildet sind, die im sichtbaren Spektralbereich oder mindestens in einem Teil dieses Spektralbereiches durchlässig sind. Ebenso kann das Bauteil auch nur in einem bestimmten Spektralbereich im Sichtbaren etwa transparent sein, so dass sich ein farbiges Bauteil ergibt. Des Weiteren kann das Bauteil eine Strukturierung derart aufweisen, dass verschiedene Areale des Bauteils verschiedenfarbig gestaltet sind beziehungsweise sich verschiedene transparente Bereiche abwechseln. Über ein transparentes Bauteil kann beispielsweise ein transparentes Leuchtmittel, etwa in Verbindung mit Fenstern, erzielt werden.

Gemäß zumindest einer Ausführungsform des organischen Licht emittierenden Bauteils emittiert dieses im Betrieb rotes, grünes und blaues Licht. Das Bauteil stellt eine so genannte RGB-Einheit dar. Ein solches organisches Bauteil kann weißes Licht emittieren und eignet sich beispielsweise zu Zwecken der Allgemeinbeleuchtung.

Es wird darüber hinaus ein Leuchtmittel angegeben. Gemäß zumindest einer Ausführungsform des Leuchtmittels umfasst dieses mindestens ein Bauteil, das beispielsweise gemäß einer oder mehrerer der oben genannten Ausführungsformen ausgestaltet sein kann. Zudem umfasst das Leuchtmittel mindestens eine Regeleinheit für Wechselstrom. Bevorzugt umfasst das Leuchtmittel eine Vielzahl von Bauteilen, die zwei- oder dreidimensional angeordnet sein können. Auch kann das Leuchtmittel verschiedene Gruppen von Bauteilen aufweisen, wobei die einzelnen Gruppen etwa jeweils Licht einer anderen Farbe emittieren und beispielsweise von separaten Regeleinheiten angesteuert werden. Ein solches Leuchtmittel kann mit Wechselstrom betrieben werden und ist großflächig herstellbar.

Gemäß zumindest einer Ausführungsform des Leuchtmittels umfasst dieses mindestens ein Bauteil mit Regeleinheit, wobei die dem Bauteil zuzuordnende Regeleinheit Bestandteil des Bauteils ist. Die Regeleinheit ist dann bevorzugt mindestens zum Teil auf demselben Substrat aufgebracht, wie die organischen Schichten des Bauteils. Bevorzugt weist das Leuchtmittel eine weitere, von dem mindestens einen Bauteil separierte Regeleinheit auf. Separiert bedeutet hierbei etwa, dass Regeleinheit und Bauteil auf unterschiedlichen Trägern angebracht sind, oder dass beispielsweise eine mechanisch flexibel ausgestaltete elektrische Leitung Bauteil und Regeleinheit verbindet. Diese separierte Regeleinheit kann von einem Netztrafo gebildet sein, der die Netzspannung auf eine niedrigere Wechselspannung transformiert. Über die dem mindestens einen Bauteil zuzuordnende Regeleinheit ist dann etwa eine Regelung der Farbe möglich. In einer alternativen Ausführungsform weist das Leuchtmittel insgesamt zur eine einzige, von dem mindestens einen Bauteil separierte Regeleinheit auf.

Im Folgenden wird das hier beschriebene organische Licht emittierende Bauteil anhand von Ausführungsbeispielen und den dazugehörigen Figuren näher erläutert.

Es zeigen:
- Figur 1a, b: schematische Seitenansichten eines Ausführungsbeispiels eines organischen Bauteils zur Erläuterung des Funktionsprinzips mit Wechselstrom,
- Figur 2: eine schematische Seitenansicht a und eine schematische Draufsicht b eines Ausführungsbeispiels eines organischen Bauteils mit Substrat,
- Figur 3: eine schematische Schnittdarstellung eines Ausführungsbeispiels eines organischen Bauteils mit einer Deckplatte,
- Figur 4: eine schematische Schnittdarstellung eines Ausführungsbeispiels eines organischen Bauteils mit einem Substrat mit einer Ausnehmung,
- Figur 5: eine schematische Draufsicht eines Ausführungsbeispiels eines organischen Bauteils mit einer auf einem Substrat angebrachten Regeleinheit, und
- Figur 6a, b: eine schematische Erläuterung der Wechselstrom-Ansteuerung eines organischen Bauteils.

In den Ausführungsbeispielen und Figuren sind gleiche oder gleich wirkende Bestandteile jeweils mit den gleichen Bezugszeichen versehen. Die dargestellten Elemente sind nicht als maßstabsgetreu anzusehen, vielmehr können einzelne Elemente zum besseren Verständnis übertrieben groß dargestellt sein. Dies gilt insbesondere für die Schichtdicken der einzelnen organischen Schichten.

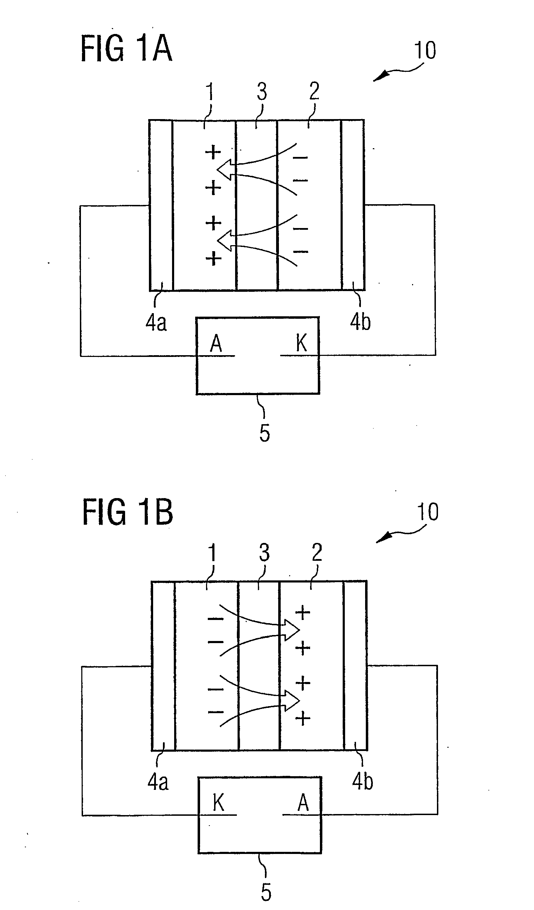

In Figur 1 ist ein Ausführungsbeispiel eines organischen Licht emittierenden Bauteils 10 dargestellt. Das organische Bauteil 10 wird mit Wechselstrom betrieben. In den Figuren 1a beziehungsweise 1b ist die elektrische Konfiguration während der positiven beziehungsweise während der negativen Phase des Wechselstroms illustriert.

Das organische Licht emittierende Bauteil 10 ist wie folgt aufgebaut: In der Mitte des Bauteils 10 ist eine Ladungsträgersperrschicht 3 angebracht. Diese Ladungsträgersperrschicht 3 ist derart gestaltet, dass sie beispielsweise von negativen Ladungsträgern - wie Elektronen durchdrungen werden kann. Positive Ladungsträger +, wie so genannte Löcher, können die Ladungsträgersperrschicht 3 jedoch nicht oder nur sehr eingeschränkt durchlaufen. Die Ladungsträgersperrschicht 3 weist über ihre gesamte Ausdehnung eine im Rahmen der Herstellungstoleranzen gleiche Materialzusammensetzung und gleiche Dicke auf. Eine Ladungsträgersperrschicht ist beispielsweise in der Druckschrift US 7,052,351 B2 offenbart.

An beiden Hauptseiten der Ladungsträgersperrschicht 3 sind eine erste 1 und eine zweite Schicht 2 aufgebracht, die dazu ausgestaltet sind, im Betrieb des Bauteils 10 elektromagnetische Strahlung zu emittieren. Erste 1 und zweite Schicht 2 sind jeweils mit mindestens einem organischen Material gestaltet. Geeignete organische Materialien werden etwa in der Druckschrift US 2006/0145599A1 beschrieben.

Auf den der Ladungsträgersperrschicht 3 abgewandten Seiten von erster 1 und zweiter Schicht 2 sind ambipolare Injektionsschichten 4a, 4b aufgebracht. Die ambipolaren Injektionsschichten 4a, 4b sind derart gestaltet, dass sowohl positive + als auch negative Ladungsträger - von den ambipolaren Injektionsschichten 4a, 4b in erste 1 beziehungsweise zweite Schicht 2 injiziert werden können. Die Injektionsschichten 4a, 4b sind elektrisch mit einer Regeleinheit 5 verbunden.

Ambipolare Ladungsträgerinjektionsschichten können auf verschiedene Weise realisiert werden. Beispielsweise können zum Erstellen einer solchen Schicht gleichzeitig Loch und Elektronen leitende Materialien aufgedampft werden. Ebenso ist es möglich, dass beispielsweise in einer Löcher leitenden Matrix ein Gradient Elektronen leitender Dotierstoffe beispielsweise mittels Aufdampfen erzeugt wird. Entsprechendes gilt für Löcher leitenden Dotierstoffe in einer Elektronen leitenden Matrix.

Alternativ kann ein ambipolares Material dadurch erzeugt werden, dass durch die Aggregation hochkonzentrierter Dopanden sich ein solches ergibt. Weiterhin kann eine ambipolare Injektionsschicht durch Koevaporation einer Matrix mit verschiedenen Materialien mit niedriger Bandlücke und unterschiedlichen absoluten HOMO-Niveaus gebildet werden, so dass eine graduelle beziehungsweise schrittweise Injektion von positiven und negativen Ladungsträgern in die Licht emittierenden Schichten möglich ist. Eine weitere Möglichkeit besteht darin, intrinsisch ambipolare Materialien einzusetzen. Solche Materialien sind zum Beispiel in der Druckschrift US 2007/0075631 A1 angegeben.

In Figur 1a ist die elektrische Konfiguration während der positiven Phase des Wechselstroms gezeigt. Während der positiven Phase ist die ambipolare Injektionsschicht 4a mit einer Anode A der Regeleinheit 5 elektrisch verbunden. Die Injektionsschicht 4b ist mit einer Kathode K der Regeleinheit 5 elektrisch leitend verbunden. Da an der Injektionsschicht 4a eine positive Spannung anliegt, werden positive Ladungsträger + von der Injektionsschicht 4a in die erste Schicht 1 injiziert. Diese positiven Ladungsträger + werden von der Injektionsschicht 4a aus aufgrund der anliegenden positiven Spannung in Richtung Ladungsträgersperrschicht 3 getrieben. Da die Ladungsträgersperrschicht 3 für positive Ladungsträger + nicht durchlässig ist, werden diese im Bereich vor der Ladungsträgersperrschicht 3 aufgehalten. Die über die Kathode K beziehungsweise die Injektionsschicht 4b in die zweite Schicht 2 injizierten negativen Ladungsträger, die von der Injektionsschicht 4b in Richtung erster Schicht 1 getrieben werden, können die Ladungsträgersperrschicht 3 jedoch durchlaufen und gelangen so in die erste Schicht 1. In der ersten Schicht 1 findet also eine Rekombination von positiven + und negativen Ladungsträgern statt. Während der positiven Phase der Wechselspannung wird also von der ersten Schicht 1 elektromagnetische Strahlung emittiert.

Figur 1b zeigt die elektrische Konfiguration während der negativen Phase der Wechselspannung. Gegenüber Figur 1a sind Anode A und Kathode K also vertauscht. Die positiven Ladungsträger + werden von der Injektionsschicht 4b in die zweite Schicht 2 injiziert und von der Ladungsträgersperrschicht 3 aufgehalten. Die über Injektionsschicht 4a injizierten negativen Ladungsträger - durchlaufen erste Schicht 1, Ladungsträgersperrschicht 3, wodurch die Ladungsträgerrekombination in der zweiten Schicht 2 stattfindet und diese Licht emittiert. Erste 1 und zweite Schicht 2 emittieren also in Abhängigkeit von der gerade anliegenden Spannung abwechselnd elektromagnetische Strahlung.

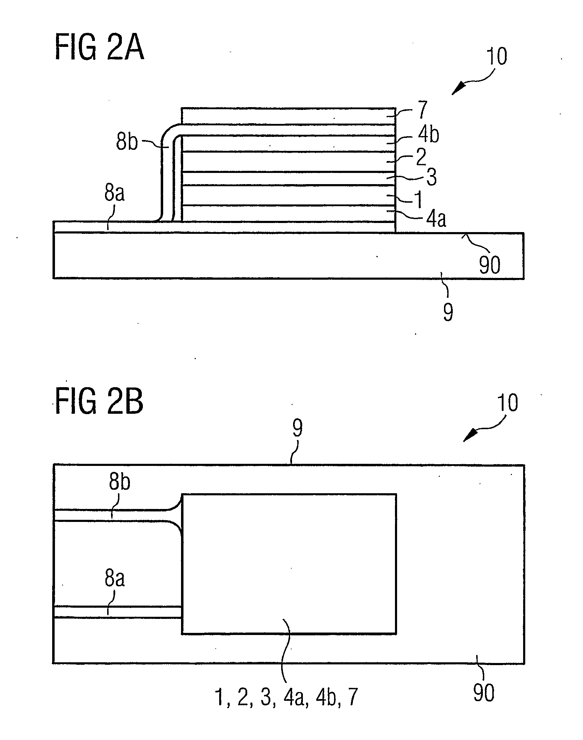

Gemäß dem Ausführungsbeispiel wie in Figur 2 dargestellt, sind die organischen Schichten 1, 2, 3, 4a, 4b über einer Montageseite 90 eines Substrats 9 angebracht. Die Montageseite 90 ist eben ausgestaltet, so dass die verschiedenen organischen Schichten auf die Montageseite 90 aufgebracht werden können. Ausgehend von der Montageseite 90 sind folgende Schichten auf dem Substrat 9 angebracht: Erste Elektrode 8a, erste ambipolare Injektionsschicht 4a, erste Schicht 1, Ladungsträgersperrschicht 3, zweite Schicht 2, zweite ambipolare Injektionsschicht 4b, zweite Elektrode 8b und eine Konversionsmittelschicht 7. Funktionsweise und Aufbau der organischen Schichten entsprechen dem Ausführungsbeispiel gemäß Figur 1.

Die Elektroden 8a und 8b sind ganzflächig an den der Ladungsträgersperrschicht 3 abgewandten Seiten der Injektionsschichten 4a, 4b aufgebracht. Die sich auf der dem Substrat 9 abgewandten Seite des Schichtenstapels befindliche Elektrode 8b ist so zur Montageseite 90 des Substrats 9 geführt, dass keine unerwünschten elektrischen Verbindungen zu anderen Schichten als der Injektionsschicht 4b auftreten. Die Elektrode 8b ist für die im Betrieb von erster 1 und zweiter Schicht 2 emittierte Strahlung durchlässig. Erste 1 und zweite Schicht 2 emittieren hierbei in unterschiedlichen Spektralbereichen. Das Konversionsmittel 7 konvertiert nur einen Teil der beispielsweise von der zweiten Schicht 2 emittierten Strahlung, so dass insgesamt ein vielfarbig emittierendes Bauteil 10 resultiert, das etwa weißes Licht abstrahlen kann. Die Elektrode 8a ist reflektierend für die vom Bauteils 10 emittierte Strahlung ausgestaltet. Die Elektroden 8a, 8b werden auf der Montageseite 90 vom Schichtenstapel 1, 2, 3, 4a, 4b in schmalen Bahnen lateral weg geführt, wie in Figur 2b zu sehen ist.

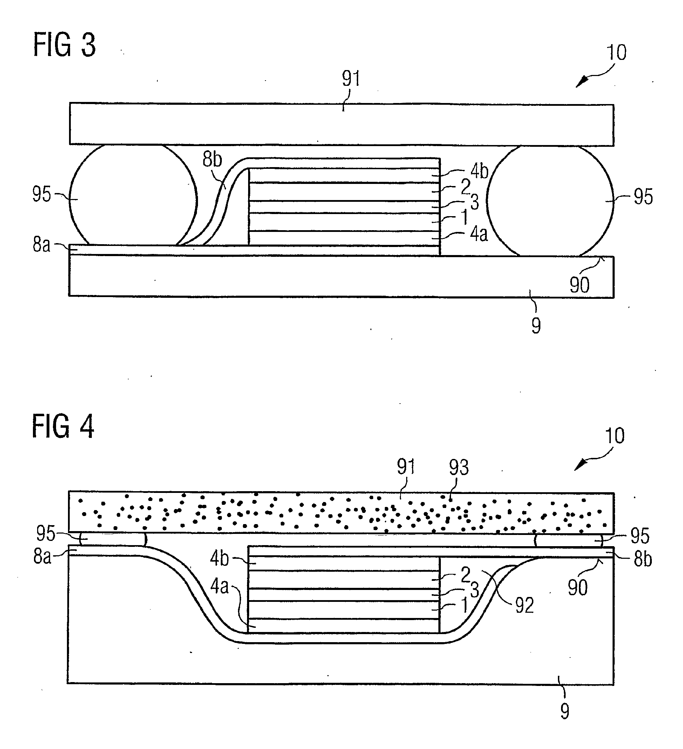

Beim Ausführungsbeispiel gemäß Figur 3 weist das Bauteil 10 neben dem Substrat 9 auch eine Deckplatte 91 auf. Substrat 9 und Deckplatte 91, die beispielsweise aus einem Kalk-Natron-Glas gebildet und eben ausgestaltet sind, sind mit einem Verbindungsmittel 95 mechanisch miteinander verbunden. Das Verbindungsmittel 95 ist als Glaslot ausgeführt. Über das Verbindungsmittel 95, Substrat 9 und Deckplatte 91 sind die organischen Schichten 1, 2, 3, 4a, 4b zudem verkapselt. Erste 1 und zweite Schicht 2 emittieren hierbei Licht im selben Spektralbereich. Substrat 9 und Deckplatte 91 sind für die von erster 1 und zweiter Schicht 2 im Betrieb emittierte Strahlung durchlässig, ebenso wie das Verbindungsmittel 95. Die Schichtenfolge der organischen Schichten 1, 2, 3, 4a, 4b entspricht dem in Figur 2 gezeigten Ausführungsbeispiel, wobei im Ausführungsbeispiel gemäß Figur 3 die Elektrode 8a ebenfalls transparent für die emittierte Strahlung ausgestaltet ist, so dass sich ein in mindestens Teilen des sichtbaren Spektralbereichs transparentes Bauteil 10 ergibt.

Beim Ausführungsbeispiel gemäß Figur 4 weist das Substrat 9 eine Ausnehmung 92 auf, in der die organischen Schichten 1, 2, 3, 4a, 4b angebracht sind. Die Elektrode 8a ist flächig auf der Montageseite 90 in der Ausnehmung 92 aufgebracht und bildet hierdurch einen Reflektor für die vom Bauteil 10 emittierte Strahlung aus. Das Substrat 9 kann aus einem Glas oder einer Kunststofffolie gebildet sein. Die Ausnehmung 92 kann über einen Stempel- oder Prägeprozess einfach und kosteneffizient erstellt werden. Dadurch, dass sich die aktiven Schichten in der Ausnehmung 92 befinden, kann die Deckplatte 91 eben gestaltet sein. Hierdurch kann sich die Höhe beziehungsweise die Ausdehnung des Verbindungsmittels 95 zwischen Deckplatte 91 und Substrat 9 signifikant verringern, so dass die laterale Ausdehnung des Verbindungsmittels 95 wesentlich größer ist als dessen vertikale Ausdehnung. Hierdurch kann eine besonders dichte Verkapselung der organischen Schichten erzielt werden, da die vom Schichtenstapel 1, 2, 3, 4a, 4b abgewandte äußere Fläche des Verbindungsmittels 95 nur sehr klein ist. Die Menge an Verbindungsmittel 95, die etwa Feuchtigkeit oder Sauerstoff über Diffusion lateral zu überwinden haben, bevor derartige Stoffe zum organischen Schichtenstapel 1, 2, 3, 4a, 4b gelangen, ist allerdings relativ groß.

Optional kann der Deckplatte 91 oder auch dem Substrat 9 eine Beimengung in Form eines Reflexionsmittels,

Diffusionsmittels, Konversionsmittels, Filtermittels oder eines Stoffes zur Anpassung des thermischen Ausdehnungskoeffizienten beigemengt sein. Alternativ ist es ebenso möglich, dass beispielsweise die Elektrode 8b reflektierend und die Elektrode 8a transparent für die vom Bauteil 10 emittierte Strahlung ausgestaltet ist. Die Ausnehmung 92 kann dann beispielsweise in Form einer Linse ausgestaltet sein, um das von erster 1 und zweiter Schicht 2 emittierte Licht etwa gleichmäßig in einen größeren Winkelbereich abzustrahlen. Als weitere Option ist es möglich, dass zwischen Montageseite 90 und Elektrode 8a eine Schicht angebracht ist, die beispielsweise eine Anpassung der Brechungsindizes von organischen Schichten 1, 2, 3, 4a, 4b und Substrat 9 ermöglicht oder auch eine Planarisierung derjenigen Bereiche der Ausnehmung 92 darstellt, auf denen die verschiedenen organischen Schichten 1, 2, 3, 4a, 4b oder die Elektrode 8a aufgebracht werden. Über eine derartige Planarisierungsschicht vereinfacht sich der Herstellungsprozess des Bauteils 10. Weiterhin ist es möglich, dass in der Ausnehmung 92 ein Absorbermaterial beziehungsweise ein Getter angebracht ist, das beispielsweise die organischen Schichten 1, 2, 3, 4a, 4b oder auch Substrat 9 und Deckplatte 91 umhüllt. Als weitere Option können Substrat 9 und/oder Deckplatte 91 Strukturierungen aufweisen, die beispielsweise die Lichtauskopplung aus dem Bauteil 10 verbessern.

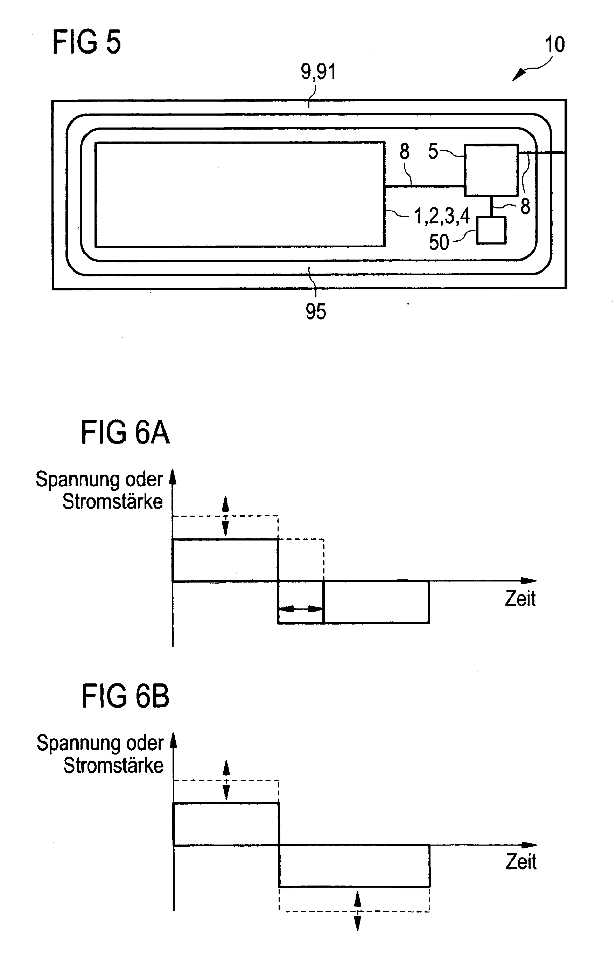

Beim Ausführungsbeispiel gemäß Figur 5 ist ein organisches Licht emittierendes Bauteil 10 dargestellt, das neben dem Schichtenstapel 1, 2, 3, 4 eine Regeleinheit 5, die zwischen Substrat 9 und Deckplatte 91 aufgebracht ist, sowie eine ebenfalls zwischen Deckplatte 91 und Substrat 9 befindlichen Sensor 50 umfasst. Schichtenstapel 1, 2, 3, 4, Regeleinheit 5 und Sensor 50 sind rahmenartig von einem Verbindungsmittel 95 umgeben, das Substrat 9 und Deckplatte 91 miteinander verbindet. Die Elektroden 8 stellen eine elektrische Verbindung von außerhalb des Verbindungsmittels 95 zum Innenbereich sowie zwischen den einzelnen Komponenten her. Die organischen Schichten 1, 2, 3, 4 sind großflächig auf dem Substrat 9 aufgebracht und nehmen den Hauptanteil der Fläche des Substrats 9 ein. Über den Sensor 50, der auch auf organischen Materialien basieren kann, können Helligkeit beziehungsweise Farbton und Farbsättigung des von den organischen Schichten 1, 2, 3, 4 im Betrieb emittierten Lichts gemessen und über die Regeleinheit 5 angepasst werden. Die Regeleinheit 5 kann ebenfalls mindestens teilweise auf organischen Materialien basieren und gänzlich oder auch nur zum Teil innerhalb des Rahmens aus Verbindungsmittel 95 auf dem Substrat 9 angebracht sein.

Optional ist es möglich, dass mehrere, auch verschiedenfarbig emittierende Schichtenstapel 1, 2, 3, 4 auf dem Substrat 9 aufgebracht sind. Pro Schichtenstapel 1, 2, 3, 4 kann eine Regeleinheit 5 und ein Sensor 50 verwendet werden. Es können aber auch mehrere Schichtenstapel 1, 2, 3, 4 über eine einzige Regeleinheit 5 angesteuert werden.

In Figur 6 ist ein Regelschema der Wechselstromregeleinheit 5 illustriert. Wie in Figur 6b dargestellt, weisen positive und negative Phase unterschiedliche Zeitdauern auf. Der Spannungsverlauf entspricht einer Rechteckspannung, kann aber ebenso sinusartig ausgestaltet sein. Über eine Veränderung der Effektivspannungen kann die Helligkeit des vom Bauteil 10 emittierten Lichts eingestellt werden.

Die Regelung von Farbton und Farbsättigung ist in Figur 6a erläutert. Werden über die Regeleinheit 5 das Tastverhältnis, das heißt, das Verhältnis von Dauer der positiven Phase und der gesamten Schwingungsdauer verändert sowie alternativ oder zusätzlich die Effektivspannung von positiver und/oder negativer Phase geregelt, so können Farbton und Farbsättigung des vom organischen Bauteil 10 emittierten Lichts gesteuert werden. Dies gilt insbesondere, wenn erste 1 und zweite Schicht 2 derart gestaltet sind, dass sie im Betrieb Licht in verschiedenen Spektralbereichen emittieren. Bevorzugt kann die Regeleinheit 5 sowohl Helligkeit als auch Farbton und Farbsättigung unabhängig voneinander gezielt ansteuern, beispielsweise unter Zuhilfenahme eines Sensors 50, wie im Ausführungsbeispiel gemäß Figur 5 dargestellt.

## Patentansprüche

1. Organisches Licht emittierendes Bauteil (10) mit
- einer unipolaren Ladungsträgersperrschicht (3),
- einer ersten Schicht (1) und einer zweiten Schicht (2), die an gegenüberliegenden Seiten der Ladungsträgersperrschicht (3) aufgebracht und jeweils mit mindestens einem organischen Material gebildet und dazu eingerichtet sind, im Betrieb des Bauteils (10) Licht zu emittieren, und
- zwei ambipolaren Injektionsschichten (4), die an den der Ladungsträgersperrschicht (3) abgewandten Seiten der ersten (1) und der zweiten Schicht (2) aufgebracht sind, und
- einer ersten und einer zweiten Elektrode (8a, 8b), von denen je eine an der Ladungsträgersperrschicht (3) abgewandten Seiten der zwei ambipolaren Injektionsschichten (4) aufgebracht ist.

2. Bauteil (10) nach Anspruch 1,
das eine Regeleinheit (5) für Wechselstrom umfasst und das dazu eingerichtet ist, mit Wechselspannung betrieben zu werden.

3. Bauteil (10) nach Anspruch 2,
mit dessen Regeleinheit (5) mindestens eine der Kenngrößen Amplituden, Amplitudenverhältnis und Tastverhältnis des Wechselstroms gesteuert wird.

4. Bauteil (10) nach einem der vorhergehenden Ansprüche, das dazu eingerichtet ist, mit Wechselspannung betrieben zu werden und bei dem im Betrieb die erste (1) und die zweite Schicht (2) dazu eingerichtet sind, abwechselnd Licht zu emittieren, in Abhängigkeit von der anliegenden Phase der Wechselspannung.

5. Bauteil (10) nach einem der vorhergehenden Ansprüche, bei dem die Ladungsträgersperrschicht (3) durchgehend und unstrukturiert ist.

6. Bauteil (10) nach einem der vorhergehenden Ansprüche, bei dem die erste (1) und die zweite Schicht (2) dazu ausgestaltet sind, im Betrieb Licht in voneinander verschiedenen Wellenlängenbereichen zu emittieren.

7. Bauteil (10) nach einem der Ansprüche 2 bis 6, bei dem mindestens eine der Kenngrößen Farbton, Farbsättigung und Helligkeit des im Betrieb emittierten Lichts über die Regeleinheit (5) gesteuert wird.

8. Bauteil (10) nach einem der vorhergehenden Ansprüche, bei dem über einer der Ladungsträgersperrschicht (3) abgewandten Seite von der ersten (1) oder von der zweiten Schicht (2) ein Konversionsmittel (7) aufgebracht ist, das mindestens einen Teil der im Betrieb emittierten Strahlung in eine Strahlung einer anderen Frequenz umwandelt.

9. Bauteil (10) nach einem der vorhergehenden Ansprüche, das ein Substrat mit einer Montageseite umfasst, auf der die erste Schicht (1), die Ladungsträgersperrschicht (3) und die zweite Schicht (2) sowie die Injektionsschichten (4) aufgebracht sind, wobei das Substrat für das im Betrieb emittierte Licht zumindest teilweise durchlässig ist.

10. Bauteil (10) nach einem der Ansprüche 1 bis 8, das ein Substrat mit einer Montageseite umfasst, auf der die erste Schicht (1), die Ladungsträgersperrschicht (3) und die zweite Schicht (2) sowie die Injektionsschichten (4) aufgebracht sind, wobei das Substrat für das im Betrieb emittierte Licht zumindest teilweise reflektierend ausgestaltet ist.

11. Bauteil (10) nach Anspruch 9 oder 10,
bei dem das Substrat mindestens eine Beimengung in Form eines Konversionsmittels, Reflexionsmittels, Streumittels oder Filtermittels enthält.

12. Bauteil (10) nach einem der vorhergehenden Ansprüche, das zumindest teilweise transparent ausgestaltet ist.

13. Bauteil (10) zumindest nach den Ansprüchen 6 und 8, das dazu eingerichtet ist, im Betrieb rotes, grünes und blaues Licht zu emittieren,
wobei das Konversionsmittel (7) dazu eingerichtet ist, nur einen Teil der von der ersten (1) oder zweiten Schicht (2) emittierten Strahlung zu konvertieren.

14. Leuchtmittel mit mindestens einem Bauteil (10) nach einem der vorhergehenden Ansprüche mit mindestens einer Regeleinheit (5) für Wechselstrom.

## Claims

1. Organic light-emitting component (10) comprising
- a unipolar charge carrier depletion layer (3),
- a first layer (1) and a second layer (2), which are applied at opposite sides of the charge carrier depletion layer (3) and are formed in each case with at least one organic material and are designed to emit light during the operation of the component (10), and
- two ambipolar injection layers (4) which are applied at the sides of the first (1) and the second layer (2) which face away from the charge carrier depletion layer (3) and
- a first and a second electrode (8a, 8b), one of which respectively is applied at sides of the two ambipolar injection layers (4) which face away from the charge carrier depletion layer (3).

2. Component (10) according to Claim 1,
which comprises a control unit (5) for AC current and which is designed to be operated with AC voltage.

3. Component (10) according to Claim 2,
the control unit (5) of which is used to control at least one of the characteristic variables of amplitudes, amplitude ratio and duty ratio of the AC current.

4. Component (10) according to any of the preceding claims, which is designed to be operated with AC voltage, and wherein during operation the first (1) and the second layer (2) are designed to emit light alternately, depending on the present phase of the AC voltage.

5. Component (10) according to any of the preceding claims, wherein the charge carrier depletion layer (3) is continuous and unstructured.

6. Component (10) according to any of the preceding claims, wherein the first (1) and the second layer (2) are configured to emit light in mutually different wavelength ranges during operation.

7. Component (10) according to any of Claims 2 to 6, wherein at least one of the characteristic variables of hue, colour saturation and brightness of the light emitted during operation is controlled by means of the control unit (5).

8. Component (10) according to any of the preceding claims, wherein a conversion means (7) is applied above a side of the first (1) or of the second layer (2) which faces away from the charge carrier depletion layer (3), said conversion means converting at least part of the radiation emitted during operation into a radiation having a different frequency.

9. Component (10) according to any of the preceding claims, which comprises a substrate having a mounting side, on which the first layer (1), the charge carrier depletion layer (3) and the second layer (2) and also the injection layers (4) are applied, wherein the substrate is at least partly transmissive to the light emitted during operation.

10. Component (10) according to any of Claims 1 to 8, which comprises a substrate having a mounting side, on which the first layer (1), the charge carrier depletion layer (3) and the second layer (2) and also the injection layers (4) are applied, wherein the substrate is configured to be at least partly reflective to the light emitted during operation.

11. Component (10) according to Claim 9 or 10,
wherein the substrate contains at least one admixture in the form of a conversion means, reflection means, scattering means or filter means.

12. Component (10) according to any of the preceding claims, which is configured to be at least partly transparent.

13. Component (10) at least according to Claims 6 and 8, which is designed to emit red, green and blue light during operation,
wherein the conversion means (7) is designed to convert only part of the radiation emitted by the first (1) or second layer (2).

14. Illuminant comprising at least one component (10) according to any of the preceding claims comprising at least one control unit (5) for AC current.

## Revendications

1. Composant (10) émettant de la lumière organique avec :
- une couche de barrière de support de charge (3) unipolaire ;
- une première couche (1) et une deuxième couche (2) appliquées sur les côtés opposés de la couche de barrière de support de charge (3) et respectivement formées d'au moins une matière organique et conçues pour émettre de la lumière (10) en situation de fonctionnement du composant ; et
- deux couches d'injection (4) ambipolaires appliquées sur les côtés (3) de la première (1) et la deuxième couche (2) opposés à la couche de barrière de support de charge ; et
- une première et une deuxième électrode (8a, 8b), parmi lesquelles chacune est respectivement appliquée sur les côtés des deux couches d'injection (4) ambipolaires opposés à la couche de barrière de support de charge (3).

2. Composant (10) selon la revendication 1, comprenant une unité de réglage (5) pour courant alternatif et conçue pour être entraînée avec une tension alternative.

3. Composant (10) selon la revendication 2, à l'aide de l'unité de réglage (5) duquel au moins une des grandeurs caractéristiques parmi l'amplitude, le rapport d'amplitude et le rapport d'impulsion/pause du courant alternatif est commandée.

4. Composant (10) selon l'une quelconque des revendications précédentes, conçu pour être entraîné à l'aide d'une tension alternative et dans lequel en fonctionnement, la première (1) et la deuxième couche (2) sont conçues pour émettre tour à tour de la lumière en fonction de la phase actuelle de la tension alternative.

5. Composant (10) selon l'une quelconque des revendications précédentes, dans lequel la couche de barrière de support de charge (3) est traversant et non structuré.

6. Composant (10) selon l'une quelconque des revendications précédentes, dans lequel la première (1) et la deuxième couche (2) sont configurées pour émettre en fonctionnement de la lumière dans des plages de longueurs d'onde différentes les unes des autres.

7. Composant (10) selon l'une quelconque des revendications 2 à 6, dans lequel au moins une des grandeurs caractéristiques, parmi la teinte, la saturation des couleurs et la luminosité, de la lumière émise en fonctionnement est commandée par le biais de l'unité de réglage (5).

8. Composant (10) selon l'une quelconque des revendications précédentes, dans lequel un moyen de conversion (7) est appliqué sur un côté de la première (1) ou de la deuxième couche (2) opposé à la couche de barrière de support de charge (3), ledit moyen convertissant au moins une partie du rayonnement émis en fonctionnement en une autre fréquence.

9. Composant (10) selon l'une quelconque des revendications précédentes, comprenant un substrat doté d'un côté de montage sur lequel la première couche (1), la couche de barrière de support de charge (3) et la deuxième couche (2) ainsi que les couches d'injection (4) sont appliquées, le substrat étant au moins en partie perméable à la lumière émise en fonctionnement.

10. Composant (10) selon l'une quelconque des revendications 1 à 8 comprenant un substrat doté d'un côté de montage sur lequel la première couche (1), la couche de barrière de support de charge (3) et la deuxième couche (2) ainsi que les couches d'injection (4) sont appliquées, le substrat étant configuré au moins en partie de façon réfléchissante pour la lumière émise en fonctionnement.

11. Composant (10) selon la revendication 9 ou 10, dans lequel le substrat contient au moins une incorporation sous la forme d'un moyen de conversion, d'un moyen de réflexion, d'un moyen de dispersion ou d'un moyen de filtrage.

12. Composant (10) selon l'une quelconque des revendications précédentes, configuré au moins en partie de façon transparente.

13. Composant (10) selon au moins les revendications 6 et 8, conçu pour émettre en fonctionnement de la lumière rouge, verte et bleue, le moyen de conversion (7) étant conçu pour convertir une partie seulement du rayonnement émis par la première (1) ou la deuxième couche (2).

14. Moyen d'éclairage doté d'au moins un composant (10) selon l'une quelconque des revendications précédentes, avec au moins une unité de réglage (5) de courant alternatif.
